# EUROPÄISCHE PATENTANMELDUNG

(11) **EP 4 386 410 A1**
(43) Veröffentlichungstag der Anmeldung: **19.06.2024**
(21) Anmeldenummer: 22214182.2
(22) Anmeldetag: 16.12.2022
(51) Int. Cl.: G01R 33/24, G01R 33/341, G01R 33/36

(54) **LOKALSPULEN MIT INTEGRIERTEN ANREGUNGSFELDSENSOREN**

(71) Anmelder: Siemens Healthineers AG, 91301 Forchheim (DE)
(72) Erfinder: Dr. Biber, Stephan, 91056 Erlangen (DE)
(74) Vertreter: Siemens Healthineers Patent Attorneys

(57) **Zusammenfassung**

In einfacher Weise soll die Sicherheit beziehungsweise die Bildqualität bei Magnetresonanzsystemen erhöht werden. Dazu wird eine Lokalspulenvorrichtung (6) vorgeschlagen, die eine erste Sensoreinrichtung (11) zum Erfassen von Magnetresonanzsignalen aufweist. Darüber hinaus besitzt die Lokalspulenvorrichtung (6) eine zweite Sensoreinrichtung (12) zum Erfassen eines Anregungssignals des Magnetresonanzsystems. Dabei ist das Anregungssignal zur Anregung der Magnetresonanzsignale durch das Magnetresonanzsystem ausgelegt.

## Beschreibung

Unabhängig vom grammatischen Geschlecht eines bestimmten Begriffes sind Personen mit männlicher, weiblicher oder anderer Geschlechteridentität mit umfasst.

Die vorliegende Erfindung betrifft eine Lokalspulenvorrichtung für ein Magnetresonanzsystem mit einer Sensoreinrichtung zum Erfassen von Magnetresonanzsignalen. Darüber hinaus betrifft die vorliegende Erfindung ein Verfahren zum Betreiben einer entsprechenden Lokalspulenvorrichtung für ein Magnetresonanzsystem, die mit einer ersten Sensoreinrichtung zum Erfassen von Magnetresonanzsignalen ausgestattet ist.

In der Kernspintomographie werden starke, hochfrequente Felder dazu genutzt, die Spins im Körper eines Patienten anzuregen. Felder im Bereich von bis zu 40 pT bei Frequenzen bis 300 MHz werden von Pulsverstärkern mit mehreren 10 kW Sendeleistung erzeugt.

Diese Sendefelder spielen eine wichtige Rolle für die Bildqualität, denn das Zeitintegral über die B1-Amplitude definiert den Flipwinkel. Falls dieser nicht homogen im gesamten Bild verteilt wird, können unerwünschte Helligkeits- oder Kontrastunterschiede im Bild entstehen, die für den Nutzer schwer interpretierbar sind. Daher ist eine möglichst homogene Verteilung des Anregungs- bzw. Sendefelds im Patienten wünschenswert. Die Homogenität wird durch die Hardware-Eigenschaften der Sendespule (meist Körperspule, d. h. Body Coil, oder selten lokale Anregungsspule, d. h. TX-LC) begrenzt, gegebenenfalls aber auch durch die Wechselwirkung des Sendefelds mit dem leitfähigen Gewebe des Patienten selbst. Aufgrund der mit der Frequenz steigenden Leitfähigkeit kommt es mit steigender Frequenz zu immer stärkeren Wirbelströmen im menschlichen Körper, die die homogene Anregung von außen deutlich erschweren und bei 7 T (300 MHz) sogar spezielle Maßnahmen (z. B. einzeln ansteuerbare Sendespulen) erfordern, um eine befriedigende Homogenisierung zu erhalten.

Die Anregungs- beziehungsweise Sendefelder der Körperspulen sind gleichzeitig eine potentielle Patientengefährdung, da sie zur Erwärmung des Patienten führen. Die Absorption der Sendefelder wird durch die Einheit SAR (spezifische Absorptionsrate) gemessen. Für die SAR gibt es normativ einzuhaltende Grenzwerte, um die Patienten nicht zu gefährden. In der Regel werden verhältnismäßig hohe Sicherheitsmargen eingehalten.

Die Überwachung der Sendefelder (d. h. der von einer Körperspule erzeugten hochfrequenten Anregungsfelder) geschieht heute beispielsweise über die Überwachung der vorwärts- und rückwärtslaufenden Welle zu den beiden Speisepunkten einer zirkular polarisierten Antenne. In früheren Systemen gab es so genannte Pick-up-Spulen in der Körperspule, die die Ströme an ausgewählten Stäben der Körperspule durch eine Probe des Feldes in deren unmittelbarer Umgebung messen konnten. Für die SAR-Überwachung stehen hierbei meist nur vier Messwerte (jeweils zwei Messungen für vorwärts- und rückwärtslaufende Welle) zur Verfügung, die die Eigenschaften der BC-Felderzeugung (Körperspule) charakterisieren. Auch zur Verbesserung der Homogenität (durch geeignete Wahl der Anregeamplituden und -phasen in Systemen mit mehr als einem Sendekanal) stehen nur diese Werte zur Verfügung, oder es muss ein echtes MR-Bild mit einer B1-Feldkarte aufgenommen werden, um die Anregeamplituden zu optimieren.

Aus der Druckschrift DE 2008 026 849 B4 ist ein Verfahren zur Feld-Qualitätsprüfung einer eine Mehrzahl von Antennenelementen umfassenden Magnetresonanz-Antennenanordnung eines Magnetresonanzsystems bekannt. Für einen Teil der zum Empfang von Magnetresonanzssignalen geeigneten Antennenelemente wird jeweils an einer Empfängereinheit ein Rauschsignal und ein mittels einer Sendeantenne in die jeweiligen Antennenelemente eingespeistes Testsignal ermittelt. Die Rauschsignale und Testsignale werden analysiert und es wird daraus ein Qualitätszustand der Magnetresonanz-Antennenanordnung ermittelt. Bislang können HF-Sendefelder am Patienten direkt nicht gemessen werden, um entsprechende Informationen zu einer Verbesserung der obigen Themen zu nutzen. Mögliche Gebiete der Verbesserung, für die dementsprechende Informationen hilfreich wären, sind z. B.:
- Verbesserung der SAR-Überwachung (eventuell können Sicherheitsmargen, die heute aufgrund eines sehr einfachen Zylinder-Mensch-Modells und der groben Annahmen über die Feldverteilung existieren, weiter reduziert werden, um so die Messgeschwindigkeit zu erhöhen)
- Verbesserung der Bildhomogenität
- Online-Überwachung des Sende- beziehungsweise TX-Feldes an verschiedensten Raumpunkten als weitere Sicherheitsmaßnahme
- Nutzung des Sendesignals anstelle eines heutigen Pilottons zur Detektion von Patientenbewegung und Atmung, eventuell sogar Herzschlag.

Sendefelder können derzeit auf das zu untersuchende Objekt nur appliziert werden, und ihre tatsächliche Verteilung kann nur im (bildgebenden) MR-Experiment dargestellt, aber nicht tatsächlich gemessen werden.

Die Aufgabe der vorliegenden Erfindung besteht somit darin, ein Sendefeld, d. h. ein Anregungssignal zur Anregung von Magnetresonanzsignalen auf einfache Weise im Untersuchungsbereich eines Magnetresonanzsystems erfassen zu können.

Erfindungsgemäß wird diese Aufgabe gelöst durch eine Lokalspulenvorrichtung und ein Verfahren gemäß den unabhängigen Ansprüchen. Vorteilhafte Weiterbildungen der Erfindung ergeben sich aus den Unteransprüchen.

Entsprechend der vorliegenden Erfindung wird demnach eine Lokalspulenvorrichtung für ein Magnetresonanzsystem bereitgestellt. Ein Magnetresonanzsystem kann als Kernspintomograph ausgeführt sein. Eine Lokalspulenvorrichtung (kurz Lokalspule genannt) dient üblicherweise dazu, Magnetresonanzsignale direkt am zu untersuchenden Objekt erfassen zu können. Beispielsweise kann eine Lokalspule direkt an einem Patienten angebracht werden, der sich in einem Patiententunnel eines Magnetresonanztomographen befindet. So können beispielsweise speziell geformte Lokalspulen am Kopf, an der Schulter oder am Knie eines Patienten angeordnet werden, um in diesen Bereichen angeregte Magnetresonanzsignale zielgerichteter erfassen zu können.

Die Lokalspulenvorrichtung weist eine erste Sensoreinrichtung zum Erfassen von Magnetresonanzsignalen auf. Die Sensoreinrichtung kann als eigentlichen Sensor eine Antenne und insbesondere eine Antennenspule aufweisen. Darüber hinaus kann die Sensoreinrichtung optional auch eine Elektronikeinheit zur Signalverarbeitung aufweisen, um Signale der Antennenspule aufzubereiten. Eine derartige Elektronikeinheit kann beispielsweise einen Verstärker, einen Schalter, einen Frequenzmultiplexer und vieles andere mehr enthalten. In jedem Fall ist die erste Sensoreinrichtung dafür geeignet, die sehr schwachen Magnetresonanzsignale zu erfassen und an eine Datenverarbeitungseinheit des Magnetresonanzsystems weiterzuleiten.

Darüber hinaus weist die Lokalspulenvorrichtung eine zweite Sensoreinrichtung zum Erfassen eines (vorgegebenen) Anregungssignals auf. Die zweite Sensoreinrichtung ist in aller Regel von der ersten Sensoreinrichtung verschieden. Unter Umständen besitzt die erste Sensoreinrichtung und die zweite Sensoreinrichtung die gleiche Hardware, aber sie sind unterschiedlich eingestellt, z. B. hinsichtlich Dämpfung beziehungsweise Verstärkung. Auch die zweite Sensoreinrichtung besitzt einen eigentlichen Sensor wie etwa eine Antenne beziehungsweise Antennenspule. Natürlich kann die zweite Sensoreinrichtung ebenso wie die erste Sensoreinrichtung auch mehrere Sensoren beziehungsweise Antennen oder Antennenspulen etc. besitzen. Optional kann die zweite Sensoreinrichtung ebenso wie die erste Sensoreinrichtung auch eine Elektronikeinheit aufweisen, um beispielsweise die Signale einer oder mehrerer Antennenspulen zu verarbeiten. Speziell ist die zweite Sensoreinrichtung dazu ausgelegt, ein Anregungssignal zu erfassen, welches zur Anregung der Magnetresonanzsignale, d.h. zur Anregung der Kernspins deren Präzession im Magnetfeld die Magnetresonanzsignale erzeugt, durch das Magnetresonanzsystem ausgelegt ist. Anregungssignale (magnetische Sendefelder) und Magnetresonanzsignale (magnetische Relaxationsimpulse) liegen in der Regel in der Amplitude um mehrere Größenordnungen, z. B. 140 dB, auseinander. Dies bedeutet, dass die erste Sensoreinrichtung in der Regel zwar zur Erfassung von Magnetresonanzsignalen geeignet ist, nicht jedoch zur Erfassung eines Anregungssignals, zumindest nicht in dem Sinne der Erfindung, dass die erste Sensoreinrichtung nicht in Sättigung geht und eine quantitative Auswertung des Anregungssignals erlaubt. In gleicher Weise ist die zweite Sensoreinrichtung in der Regel zwar dazu geeignet, ein Anregungssignal zu erfassen, aber nicht dazu, ein Magnetresonanzsignal zu erfassen, da dieses unterhalb der Rauschgrenze liegt. So liegen Magnetresonanzsignale üblicherweise in einem vorgegebenen ersten Signalstärkebereich, während das Anregungssignal üblicherweise in einem vom ersten verschiedenen zweiten Signalstärkebereich liegt.

In vorteilhafter Weise können mit der erfindungsgemäßen Lokalspulenvorrichtung somit auch TX- beziehungsweise Sendefelder direkt lokal am zu untersuchenden Objekt (z. B. Patient) überwacht werden. Somit kann ohne ein separates Gerät neben einer Lokalspule ein Sendefeld direkt am Patienten sehr genau erfasst werden.

Das erfindungsgemäße Magnetresonanzsystem weist eine erfindungsgemäße Lokalspulenvorrichtung auf. Die Lokalspulenvorrichtung steht über einen Signalausgang in Signalverbindung mit der Sende-Empfangseinheit. Über den Signalausgang überträgt die Lokalspulenvorrichtung das erfasste Magnetresonanzsignal und das erfasste Anregungssignal, d.h. aufgrund des zeitlichen Versatzes nicht gleichzeitig, aber auf dem gleichen Weg und mit der gleichen Übertragungstechnik. Näheres zum Signalausgang und der Übertragungstechnik ist nachfolgend ausgeführt.

Die Sende-Empfangseinheit ist dabei ausgelegt, wahlweise ein von der Lokalspuleneinrichtung erfasstes Magnetresonanzsignal und/oder Anregungssignal auszuwerten. Vorzugsweise ist dabei die erfindungsgemäße Lokalspulenvorrichtung so ausgelegt, dass die Sende-Empfangseinheit sowohl das Anregungssignal als auch das Magnetresonanzsignal mit der gleichen Empfänger-Hardware auswerten kann. Beispielsweise sind Amplitudenbereiche und Frequenzbereiche der Signale der Lokalspuleneinrichtung so gewählt, dass beide einen Empfänger der Sende-Empfangseinheit nicht übersteuern und quantitativ ausgewertet werden können. Es ist aber denkbar, dass beispielsweise einstellbare Filter und Dämpfungsglieder sowie Algorithmen unterschiedlich für die Auswertung beider Signale eingestellt werden.

Auf vorteilhafte Weise ermöglicht es die erfindungsgemäße Lokalspuleneinrichtung mit den gleichen Empfängern der Sende-Empfangseinheit sowohl die Anregungspulse zu überwachen als auch die Magnetresonanzsignale zu erfassen. So ist es möglich, ohne zusätzliche Hardware die Sicherheit und Genauigkeit beim Betrieb des Magnetresonanztomographen zu verbessern.

Weitere vorteilhafte Ausführungsformen sind zu den Unteransprüchen angegeben.

In einer Ausführungsform ist vorgesehen, dass die erste Sensoreinrichtung und die zweite Sensoreinrichtung (mindestens) eine Antennenspule gemeinsam besitzen, die erste Sensoreinrichtung eine erste Elektronikeinheit zum Verarbeiten der mittels der Antennenspule erfassten Magnetresonanzsignale und die zweite Sensoreinrichtung eine von der ersten verschiedene zweite Elektronikeinheit zur Signalverarbeitung des erfassten Anregungssignals besitzt, und die Lokalspulenvorrichtung eine Schalteinrichtung aufweist, mit der die Antennenspule wechselweise zur ersten oder zweiten Elektronikeinheit schaltbar ist. Dies bedeutet, dass sich die erste Sensoreinrichtung und die zweite Sensoreinrichtung überschneiden, denn sie umfassen eine gemeinsame Antennenspule. Hingegen besitzen die erste und die zweite Sensoreinrichtung unterschiedliche Elektronikeinheiten. Während die erste Elektronikeinheit der ersten Sensoreinrichtung die sehr schwachen Magnetresonanzsignale verarbeiten kann, kann die zweite Elektronikeinheit der zweiten Sensoreinrichtung die sehr starken Anregungssignale insbesondere entsprechende Erfassungssignale von Hochfrequenzfeldern leistungsstarker Körperspulen verarbeiten. Unter einer Verarbeitung wird hier insbesondere ein nicht nur binäres Verarbeiten, sondern insbesondere ein (proportionales) Verarbeiten in Abhängigkeit von der jeweiligen Signalstärke verstanden. In vorteilhafter Weise ist es so möglich, die Antennenspulen einer Lokalspule auch für die Erfassung von Sendefeldern zu nutzen. Es ist lediglich eine geeignete zusätzliche Elektronikeinheit in der Lokalspule vorzusehen.

In einer konkreten Ausführungsform kann vorgesehen sein, dass die erste Elektronikeinheit eine niedrigere Dämpfung oder eine höhere Verstärkung aufweist als die zweite Elektronikeinheit. Eine niedrigere Dämpfung kann beispielsweise durch eine niedrigere Impedanz (Wechselstromwiderstand) erreicht werden. Dem entsprechend besitzt die erste Elektronikeinheit gegenüber der zweiten Elektronikeinheit eine hohe Einkopplung beziehungsweise eine schwache Dämpfung. Alternativ oder zusätzlich können die erste und die zweite Elektronikeinheit auch jeweils einen Verstärker aufweisen, wobei die Verstärkung der ersten Elektronikeinheit, mit der die Magnetresonanzsignale beziehungsweise deren Erfassungssignale verstärkt werden, eine höhere Verstärkung besitzt als die zweite Elektronikeinheit, mit der die ohnehin starken Anregungssignale beziehungsweise deren Erfassungssignale verarbeitet werden. Gegebenenfalls besitzt die zweite Elektronikeinheit auch keine Verstärkung und gegebenenfalls nur eine Dämpfung.

In einem alternativen Ausführungsbeispiel ist vorgesehen, dass die erste Sensoreinrichtung (mindestens) eine erste Antennenspule und die zweite Sensoreinrichtung (mindestens) eine von der ersten verschiedene zweite Antennenspule besitzt. In diesem Fall sind also eine oder mehrere Antennenspulen für die Erfassung der Magnetresonanzsignale und eine oder mehrere Antennenspulen für die Erfassung des Anregungssignals in der Lokalspulenvorrichtung bereitgestellt. Dies hat den Vorteil, dass die jeweiligen Antennenspulen spezifisch auf die unterschiedlichen Signalstärken ausgelegt werden können.

In einer Weiterbildung dieser Lokalspulenvorrichtung können die erste Sensoreinrichtung und die zweite Sensoreinrichtung (zumindest teilweise) eine gemeinsame Elektronikeinheit zur Signalverarbeitung und einen gemeinsamen Signalausgang besitzen. Die Überschneidung der Sensoreinrichtungen besteht hier also darin, dass nur die Elektronikeinheit gemeinsam genutzt wird, aber jede Sensoreinrichtung ihre eigenen Antennenspulen besitzt. Die unterschiedlichen Antennenspulen können hierbei unterschiedliche Einkopplungsgrade in die Elektronikeinheit besitzen. Insbesondere sollte die zweite Sensoreinrichtung eine schwächere Einkopplung beziehungsweise einen geringeren Einkopplungsgrad besitzen. Insbesondere kann bei der zweiten Sensoreinrichtung eine höhere Verstimmung oder eine höhere Dämpfung zwischen den Antennenspulen und der Elektronikeinheit gewählt werden als bei der ersten Sensoreinrichtung. Aufgrund der gemeinsamen Elektronikeinheit ergibt sich auch ein gemeinsamer Signalausgang. Für die Erfassung des Anregungssignals ist also kein separater Signalausgang vorzusehen. Vielmehr können die Erfassungssignale in Bezug auf die Magnetresonanzsignale und die Anregungssignale über einen gemeinsamen Signalausgang von der Lokalspulenvorrichtung an eine weitere Verarbeitungsvorrichtung weitergeleitet werden.

In einem weiteren Ausführungsbeispiel ist vorgesehen, dass die erste Antennenspule der ersten Sensoreinrichtung zusammen mit der zweiten Antennenspule der zweiten Sensoreinrichtung auf einer gemeinsamen Leiterplatte angeordnet ist. In gleicher Weise können natürlich auch mehrere Antennenspulen der ersten Sensoreinrichtung sowie mehrere Antennenspulen der zweiten Sensoreinrichtung auf einer gemeinsamen Leiterplatte angeordnet sein. Hierdurch lassen sich nicht nur die Herstellungskosten vermindern, sondern es ergibt sich auch eine besonders einfache Positionsbestimmung der jeweiligen Antennenspulen.

Gemäß einem weiteren Ausführungsbeispiel kann die Lokalspulenvorrichtung einen Signalausgangspfad aufweisen, an den die erste Sensoreinrichtung und die zweite Sensoreinrichtung über einen (Wechsel-) Schalter schaltbar sind. Ein solcher Schalter kann durch eine PIN-Diode oder einen Transistorschalter realisiert werden. Vor oder nach dem Schalter können weitere Elektronikkomponenten vorgesehen sein. Der Schalter kann zur ersten und/oder zweiten Elektronikeinheit gerechnet werden. Die Lokalspulenvorrichtung kann hier eine Schnittstelle für ein extern bereitgestelltes Steuersignal aufweisen. Insbesondere kann eine Steuerleitung von einer Zentralsteuereinheit des Magnetresonanzsystems zu der Lokalspulenvorrichtung ausgebildet sein, um entsprechend der Frequenz der Sendefelder (Anregungssignale) den Schalter zu steuern. In der Sendephase sollte die zweite Sensoreinrichtung eingeschaltet sein, während in der Empfangsphase die erste Sensoreinrichtung eingeschaltet sein sollte.

In einem weiteren Ausführungsbeispiel ist vorgesehen, dass sämtliche Antennenspulen der ersten Sensoreinrichtung und sämtliche Antennenspulen der zweiten Sensoreinrichtung über einen gemeinsamen Frequenzmultiplexer an einen gemeinsamen Signalausgangspfad der Lokalspulenvorrichtung schaltbar sind. Beispielsweise werden die jeweiligen Antennenspulensignale mit unterschiedlichen Frequenzen gemischt und anschließend zu einem gemeinsamen Signal überlagert. Auf diese Weise lassen sich sämtliche Erfassungssignale mehrerer Antennenspulen gleichzeitig über eine Leitung nach außen transportieren. Gegebenenfalls werden die Signale mehrerer Antennenspulen unterschiedlichen Vorverarbeitungen unterworfen, bevor sie dem Frequenzmultiplex unterzogen werden. Unter Umständen werden auch Frequenzumsetzer eingesetzt, mit denen Signale der Sensoreinrichtungen auf jeweilige Zwischenfrequenzen umsetzbar sind, so dass die Multiplexfunktion sowohl für Magnetresonanzsignale (RX) als auch für Sendesignale (TX) genutzt werden kann.

Die Signalverbindung von einem Signalausgang der Lokalspulenvorrichtung zu dem MRT-System kann dabei eine drahtgebundene Übertragungstechnik aufweisen, eine optische auf einem Wellenleiter oder auch eine drahtlose Übertragungstechnik mittels elektromagnetischer Wellen, beispielsweise Radiowellen zwischen 1 MHz und 100 GHz oder auch im infraroten oder optischen Frequenzbereich. Die Signalverbindung kann dabei eine analoge oder digitale Übertragungstechnik verwenden.

Erfindungsgemäß kann auch eine Lokalspulenanordnung mit einer oben beschriebenen Lokalspulenvorrichtung bereitgestellt werden. Die Lokalspulenanordnung besitzt weiterhin eine an die Lokalspulenvorrichtung signaltechnisch angeschlossene Auswerteeinrichtung. Die Auswerteeinrichtung ist also außerhalb der Lokalspulenvorrichtung angeordnet. Sie ist ausgebildet zum nicht ausschließlich binären, quantitativen Ermitteln einer Signalstärke des von der Lokalspulenvorrichtung erfassten Anregungssignals des Magnetresonanzsystems innerhalb eines vorgegebenen Signalstärkebereichs. Das "nicht ausschließlich binäre Ermitteln" bedeutet, dass nicht nur festgestellt werden kann, ob ein Signal vorliegt oder nicht, sondern dass die Signalstärke in mehr als zwei Stufen insbesondere kontinuierlich beziehungsweise quasi kontinuierlich ermittelt werden kann. Beispielsweise kann so ein Messsignal an die Auswerteeinrichtung übertragen werden, dessen Signalstärke proportional zur Signalstärke des Anregungssignals ist oder in einem anderen funktionellen Zusammenhang steht. Somit kann das Anregungssignal hinsichtlich quantitativer Signalstärke genau erfasst werden.

Bei der Lokalspulenanordnung kann entsprechend einem Ausführungsbeispiel vorgesehen sein, dass die zweite Sensorvorrichtung eine oder mehrere Antennen aufweist, und eine jeweilige Relativposition jeder Antenne innerhalb der Lokalspulenvorrichtung für die Auswerteeinrichtung zur Optimierung einer Homogenität des Anregungssignals zur Verfügung gestellt ist. Innerhalb des Auswertungsbereichs der Lokalspulenvorrichtung kann somit das Anregungssignal hinsichtlich Homogenität nachjustiert werden. Dies ist insbesondere deswegen möglich, da die jeweiligen Antennenpositionen der ersten Sensorvorrichtung für die Erfassung des Anregungssignals bekannt sind. Damit kann die Auswerteeinrichtung gegebenenfalls die Magneteinrichtung des Magnetresonanzsystems so steuern, dass das Anregungssignal im Erfassungsbereich der Lokalspulenvorrichtung homogen ist.

In einem weiteren Ausführungsbeispiel ist die Lokalspulenanordnung in einem ersten Zustand des Erfassens mit der ersten Sensoreinrichtung und in einem zweiten Zustand des Erfassens mit der zweiten Sensoreinrichtung schaltbar, wobei die Auswerteeinrichtung dazu eingerichtet ist, dass eine Auflösungsbandbreite der Auswerteeinrichtung automatisch in Abhängigkeit von dem jeweiligen Zustand parametrisiert wird. Beispielsweise ist für die Erfassung der Magnetresonanzsignale eine andere Auflösung notwendig als für die Erfassung des Anregungssignals. In diesem Fall kann ein Schaltsignal, das zum Umschalten der beiden Sensoreinrichtungen verwendet wird, auch dazu genutzt werden, die Auflösungsbandbreite der Auswerteeinrichtung entsprechend umzuschalten. Damit ist für jeden Zustand die passende Auflösung gewählt.

Erfindungsgemäß wird die oben genannte Aufgabe auch gelöst durch ein Verfahren zum Betreiben einer Lokalspulenvorrichtung für ein Magnetresonanzsystem, die mit einer ersten Sensoreinrichtung zum Erfassen von Magnetresonanzsignalen ausgestattet ist, durch Erfassen eines Anregungssignals des Magnetresonanzsystems mittels einer zweiten Sensoreinrichtung der Lokalspule, wobei das Anregungssignal zur Anregung der Magnetresonanzsignale durch das Magnetresonanzsystem ausgelegt ist.

Die oben im Zusammenhang mit der erfindungsgemäßen Lokalspulenvorrichtung beziehungsweise der Lokalspulenanordnung genannten Vorteile und Weiterbildungsmöglichkeiten gelten sinngemäß auch für das erfindungsgemäße Verfahren. Dabei können die genannten funktionellen Merkmale als entsprechende Verfahrensschritte gesehen werden.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Hierzu zeigt:
- FIG 1: eine schematische Ansicht eines Magnetresonanzsystems;
- FIG 2: ein erstes Ausführungsbeispiel einer Lokalspulenvorrichtung;
- FIG 3: ein zweites Ausführungsbeispiel einer Lokalspulenvorrichtung; und
- FIG 4: ein Blockablaufdiagramm eines erfindungsgemäßen Verfahrens.

Die nachfolgend näher geschilderten Ausführungsbeispiele stellen bevorzugte Ausführungsformen der vorliegenden Erfindung dar.

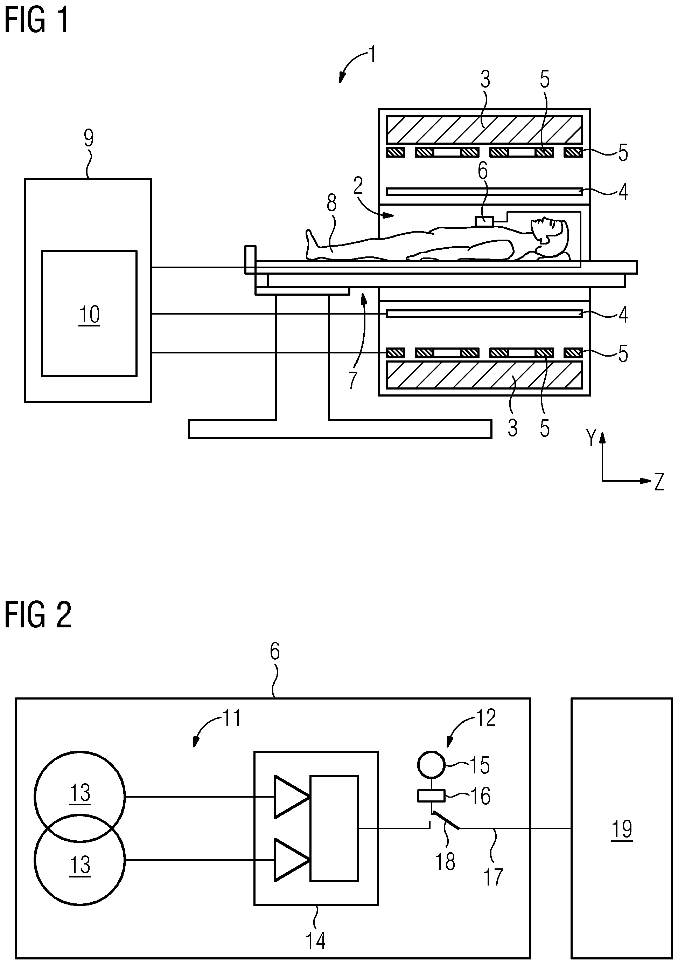

FIG 1 zeigt eine schematische Darstellung einer beispielhaften Ausführungsform eines erfindungsgemäßen (MRT-) Systems 1 (auch als Magnetresonanzsystem bezeichnet).

Das MRT-System 1 umfasst eine Magneteinheit mit einem Feldmagneten 3, der ein statisches Magnetfeld zur Ausrichtung von Kernspins eines Objekts 8, zum Beispiel eines Patienten, in einem Bildgebungsbereich erzeugt. Der Bildgebungsbereich ist durch ein äußerst homogenes statisches Magnetfeld gekennzeichnet, wobei sich die Homogenität insbesondere auf die Magnetfeldstärke beziehungsweise deren Amplitude bezieht. Der Bildgebungsbereich befindet sich in einem Patiententunnel 2, der sich in einer Längsrichtung Z durch die Magneteinheit erstreckt. Der Feldmagnet 3 kann beispielsweise ein supraleitender Magnet sein, der Magnetfelder mit einer magnetischen Flussdichte von bis zu 3 T oder mehr erzeugen kann. Für geringere Feldstärken können jedoch auch Permanentmagnete oder Elektromagnete mit normalleitenden Spulen verwendet werden. Ein Patiententisch 7 kann innerhalb des Patiententunnels 2 beweglich sein.

Weiterhin umfasst die Magneteinheit eine Gradientenspulenanordnung 5 mit mehreren Gradientenspulen, die dazu dienen, dem statischen Magnetfeld Gradientenfelder, also ortsabhängige Magnetfelder, in den drei Raumrichtungen zur räumlichen Differenzierung der abgetasteten Bildbereiche im Bildgebungsbereich zu überlagern. Die Gradientenspulen der Gradientenspulenanordnung 5 können zum Beispiel als Spulen aus normalleitenden Drähten ausgebildet sein, die zum Beispiel zueinander orthogonale Felder oder Feldgradienten im Bildgebungsbereich erzeugen können.

Die Magneteinheit umfasst eine Sendespulenanordnung, die beispielsweise eine Körperspule 4 (auch als Ganzkörperspule oder Body Coil bezeichnet) als Sendeantenne umfassen kann, die dazu ausgebildet ist, ein Hochfrequenzsignal in den Bildgebungsbereich abzustrahlen. Die Körperspule 4 kann daher als HF-Sendespulenanordnung des MRT-Systems 1 verstanden werden oder als Teil der HF-Sendespulenanordnung. Die Körperspule 4 kann in einigen Ausführungsformen auch dazu verwendet werden, resonante MR-Signale zu empfangen, die von dem Objekt 8 ausgesendet werden. In diesem Fall kann die Körperspule 4 auch als Teil einer Signalerfassungsvorrichtung des MRT-Systems 1 betrachtet werden. Optional umfasst die Signalerfassungsvorrichtung eine Lokalspulenvorrichtung 6 bzw. Lokalspulenvorrichtung, die in unmittelbarer Nähe des Objekts 8, zum Beispiel an dem Objekt 8 oder in dem Patiententisch 7, angeordnet sein kann. Die Lokalspulenvorrichtung 6 kann alternativ oder zusätzlich zur Körperspule 4 als Empfangsspule beziehungsweise Empfangsantenne dienen.

Im Sinne der Erfindung ist die Lokalspulenvorrichtung 6 wie nachfolgend dargestellt, auch mit einem Sensor zum Erfassen der von der Körperspule 4 ausgesendeten Anregungspulse versehen.

Die Lokalspulenvorrichtung 6 steht über einen Signalausgang 17 mit dem MRT-System 1 in Signalverbindung, um die erfassten Magnetresonanzsignale und die erfassten Anregungssignale zur weiteren Auswertung zu übertragen. Die Signalverbindung kann drahtgebunden, beispielsweise über einen oder vorzugsweise mehrere Koaxialkabel oder Twisted-Pair-Leitungen, optische Wellenleiter oder auch drahtlos über eine Funkverbindung oder optische Übertragung ausgebildet sein.

Das MRT-System 1 umfasst auch ein Steuer- und Rechensystem 9. Das Steuer- und Rechensystem 9 kann eine Sende-Empfangssteuereinheit 10 umfassen, die mit der Körperspule 4, der Gradientenspulenanordnung 5 und/oder der Lokalspulenvorrichtung 6 verbunden ist. In Abhängigkeit von den erfassten MR-Signalen kann die Sende-Empfangssteuereinheit 10, die einen Analog-Digital-Wandler, ADC (englisch: "analog-to-digital converter") umfassen kann, entsprechende MR-Daten, insbesondere im k-Raum, erzeugen. Die Sende-Empfangssteuereinheit 10 ist gegebenenfalls auch mit der Körperspule 4 verbunden und steuert diese zur Erzeugung von HF-Impulsen, wie Anregungsimpulsen und/oder Refokussierungsimpulsen, an. Weiterhin kann die Sende-Empfangssteuereinheit 10 des Steuer- und Rechensystems 9 auch mit der Gradientenspulenanordnung 5 verbunden sein und diese steuern, um Schichtselektionsgradienten, Gradienten für die Frequenz- und/oder Phasencodierung und/oder Auslesegradienten zu schalten.

Erfindungsgemäß soll eine Hochfrequenzsensorik beispielsweise am Patienten bereitgestellt werden, welche geeignet ist, die hochfrequenten Sendefelder aufzunehmen und die Informationen zu einer Verbesserung der Homogenität oder der SAR-Überwachung bereitzustellen. Insbesondere sollen bestehende Lokalspulen für die Überwachung der Sendefelder genutzt werden, ohne dass deren Elektronik von den TX- beziehungsweise Sendepulsen übersteuert oder gar zerstört werden würde.

Speziell wird die Integration von TX-Feldsensorik in bestehende Lokalspulen beziehungsweise Lokalspulenvorrichtungen vorgeschlagen. Während der Sendephase sammeln die Lokalspulen wie sonst während der Empfangsphase das Feld des Sendepulses auf und liefern es an den Empfänger. Dieser kann die Daten digitalisieren und sie zur Nachverarbeitung dem Magnetresonanzsystem zur Verfügung stellen.

FIG 2 zeigt schematisch ein Ausführungsbeispiel einer Lokalspulenvorrichtung 6. Sie weist eine erste Sensoreinrichtung 11 und eine zweite Sensoreinrichtung 12 auf. Die erste Sensoreinrichtung 11 besitzt eine oder mehrere Antennenspulen 13 zur Aufnahme von RX- beziehungsweise Magnetresonanzsignalen. Im vorliegenden Fall besitzt die erste Sensoreinrichtung 11 zwei Antennenspulen 13. Außerdem besitzt die erste Sensoreinrichtung 11 hier eine erste Elektronikeinheit 14. Jede der beiden Antennenspulen 13 ist an einen Eingang der ersten Elektronikeinheit 14 geschaltet. Die erste Elektronikeinheit 14 kann Verstärkerelemente aufweisen, um die Signale der Antennenspulen 13 zu verstärken. Außerdem kann sie einen Frequenzmultiplexer besitzen, um die Eingangssignale auf ein gemeinsames Ausgangssignal zu kombinieren. Für eine derartige Kombination können auch andere Multiplex-Verfahren, wie Zeit-Multiplex, verwendet werden.

Die zweite Sensoreinrichtung 12 besitzt hier eine zweite Antennenspule 15. Die zweite Antennenspule 15 ist mit ihrem Signalausgang an ein optionales Dämpfungselement 16 angeschlossen. Die zweite Antennenspule 15 dient zum Erfassen eines TX- beziehungsweise Sendefelds der Körperspule 4. Dieses Signal kann durchaus einen Unterschied von 140 dB gegenüber Magnetresonanzsignalen aufweisen. Daher kann es günstig sein, der zweiten Antennenspule 15 das Dämpfungselement 16 nachzuschalten. Das Dämpfungselement 16 kann Teil einer zweiten Elektronikeinheit der zweiten Sensoreinrichtung sein. Gegebenenfalls ist sie die einzige Komponente der zweiten Elektronikeinheit.

Die Lokalspulenvorrichtung 6 besitzt hier einen gemeinsamen Signalausgang 17. Über einen Wechselschalter 18 kann wechselweise die erste Sensoreinrichtung 11 oder die zweite Sensoreinrichtung 12 beziehungsweise die erste Elektronikeinheit 14 oder die zweite Elektronikeinheit an den gemeinsamen Signalausgang 17 geschaltet werden. Dies bedeutet, dass sämtliche Erfassungssignale der ersten Antennenspulen 13 und der zweiten Antennenspule(n) 15 über den gemeinsamen Signalausgang 17 zu einer Auswerteeinrichtung 19 geleitet werden können. Die Auswerteeinrichtung 19 kann Teil des Magnetresonanzsystems 1 sein.

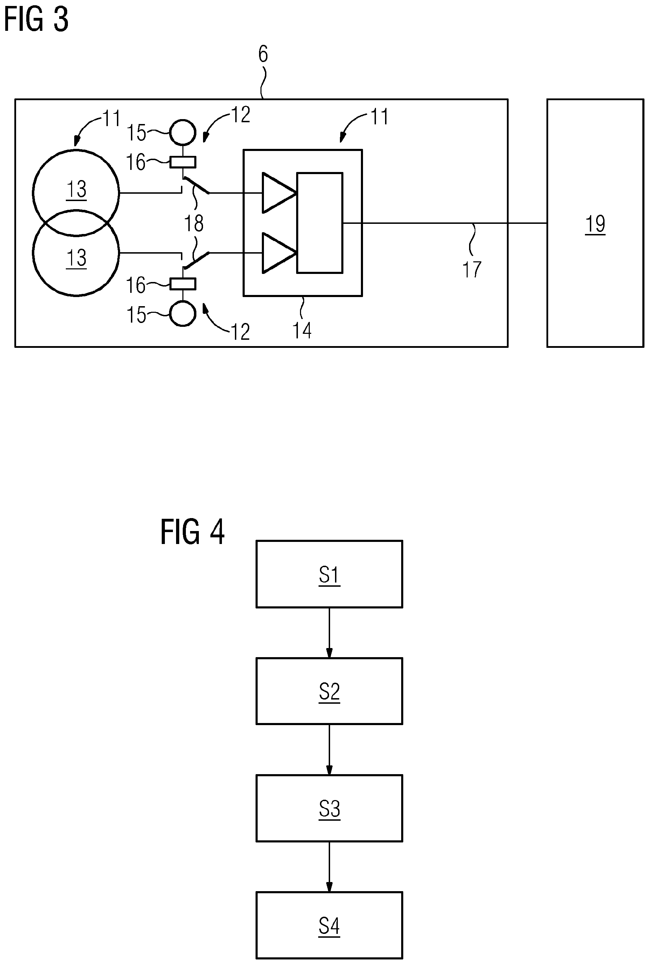

FIG 3 zeigt ein weiteres Ausführungsbeispiel einer erfindungsgemäßen Lokalspulenvorrichtung 6. Sie ist ähnlich aufgebaut wie die Lokalspulenvorrichtung 6 von FIG 2. Im Folgenden werden lediglich die Unterschiede beschrieben. Die Lokalspulenvorrichtung 6 besitzt hier zwei zweite Antennenspulen 15. Jeder zweiten Antennenspule 15 ist auch hier gegebenenfalls ein Dämpfungsglied 16 nachgeschaltet. Der (Frequenz)-Multiplexer der ersten Elektronikeinheit 14 der ersten Sensoreinrichtung 11 besitzt auch hier jeweils einen Eingang für jede der ersten Antennenspulen 13. Im vorliegenden Fall also zwei Eingänge. An jedem der Eingänge ist jeweils ein Wechselschalter 18 vorgesehen. Mit dem jeweiligen Wechselschalter 18 kann entweder die erste Antennenspule 13 oder die zweite Antennenspule 15 an den jeweiligen Eingang des (Frequenz)-Multiplexers geschaltet werden. Jeder Eingang des Multiplexers kann somit abwechselnd zur TX- und RX-Detektion verwendet werden.

Die erste Elektronikeinheit 14 kann hier als gemeinsame Elektronikeinheit für beide Sensoreinrichtungen 11 und 12 verstanden werden. Die zweiten Sensoreinrichtungen 12 besitzen hier die zusätzlichen Dämpfungselemente 16, welche zusätzliche Elektronikeinheiten darstellen können.

Da die zweiten Antennenspulen 15 ebenso wie die ersten Antennenspulen 14 am Eingang des Multiplexers liegen, können ebenso viele zweite Antennenspulen wie erste Antennenspulen genutzt werden. Im Gegensatz dazu kann in dem Fall von FIG 2 nur eine einzige zweite Antennenspule 15 eingesetzt werden, da sie im dortigen Ausführungsbeispiel an den Ausgang des Multiplexers geschaltet ist.

Nachfolgend werden Variationsmöglichkeiten der Komponenten der Lokalspulenvorrichtung 6 für die RX- und TX-Detektion beschrieben. Ähnlich wie in dem Fall von FIG 2 kann eine oder mehrere zweite Antennenspulen 15 (TX-Sensoren) ohne aktive Elektronik in die Lokalspulenvorrichtung 6 eingebracht werden. Dabei können sich folgende Untervarianten ergeben:
- Die zweiten Antennenspulen 15 werden als eigene, kleine, nicht resonante Antennen (z. B. mit einem Durchmesser von 1 bis 50 mm) ausgebildet. Diese können auf einem PCB-Board einer Verstimmelektronik oder auf einer Leiterplatte der ersten Elektronikeinheit 14 mit aufgebracht werden oder aus diskreten Bauteilen aufgebaut sein. Dadurch entstehen kaum weitere Kosten. Die Antennenspule 15 ist mit dem TX-Detektionspfad (Signalausgang 17) verbunden.
- Die bestehenden ersten Antennenspulen 13 werden auch für die Detektion der Sendefelder benutzt. Dazu werden die ersten Antennenspulen 13 (RX-Antennen) in der Sendephase nur schwach angekoppelt. Somit wird nur ein kleiner Teil des Sendesignals, das dort Strom induziert, um nur einen kleinen Signalanteil über den Ausgangspfad der Lokalspulenvorrichtung 6 zu schicken. Separate zweite Antennenspulen 15 sind in diesem Fall nicht vorgesehen. Die erste Sensoreinrichtung und die zweite Sensoreinrichtung teilen sich also die ersten Antennenspulen 13.
- Eines oder mehrere Dämpfungsglieder (innerhalb der jeweiligen Spule) zwischen den ersten Antennenspulen 13 und der Auswerteeinrichtung 19 dienen der Signalanpassung und der Unterdrückung von Stehwelleneffekten.

Für jede Leitung zur Lokalspulenvorrichtung 6 besteht damit die Möglichkeit, einen Sensor für das Sendefeld einzubauen. Bei zwei Leitungen können entsprechend zwei TX-Sensoren verbaut werden.

Alternativ können die zweiten Antennenspulen (TX-Sensoren) auch mit aktiver Elektronik verwendet werden. Hierbei können folgende Fälle unterschieden werden:
- Das Sendefeld wird durch die jeweiligen Antennenspulen so aufgenommen, dass die erste Elektronikeinheit für das Verarbeiten der Erfassungssignale der Magnetresonanzsignale nicht übersteuern. Die Erfassungssignale für die Sendefelder können somit auf die RX-Elektronik (erste Elektronikeinheit 14) gegeben werden. Diese Elektronikeinheit kann einen Mischer oder einen LNC (Low Noise Converter) beinhalten. Damit ist es möglich, die Frequenzmultiplexfunktion der RX-Detektion auch für die TX-Detektion zu nutzen. Außerdem können ebenso viele TX-Sensorelemente wie RX-Sensorelemente in der Lokalspulenvorrichtung platziert werden.
- Die Umschaltung der Sensorsignale in der Sendephase und der Empfangsphase kann durch konventionelle Schalter erfolgen, wie etwa PIN-Dioden oder Transistorschalter.

Die ersten Antennenspulen 13 (RX-Spulen) können gemäß FIG 2 eine Umschaltung im Empfangspfad besitzen. Das bedeutet, dass das Kabel, das zur Rücklieferung von RX-Signalen dient, auch zur Rücklieferung von TX-Signalen genutzt werden kann. Dies kann auf verschiedene Weisen realisiert werden:
- Es wird gemäß FIG 2 der Schalter 18 zwischen die erste Elektronikeinheit 14 und die zweite Antennenspule 15 zur Sendefelddetektion eingebaut. Somit kann zwischen beiden Signalkanälen umgeschaltet werden. Als Schaltsignal kann das ohnehin vorhandene PIN-Diodensignal genutzt werden.
- Gegebenenfalls kann das TX-Detektionssignal auf die Ausgangsleitung der Lokalspulenvorrichtung aufgekoppelt werden (induktiv, kapazitiv oder resistiv durch einen so genannten Power-Combiner). Das TX-Detektionselement sollte dann so ausgestaltet sein, dass im Sendefall das Signal aus dem TX-Detektionselement das Signal aus dem RX-Pfad immer deutlich überspricht.

Für genaue Messungen ist es notwendig, die Komponenten der Lokalspulenvorrichtung zu kalibrieren. Nur so sind quantitative Interpretationen der Daten möglich. Für die Kalibrierung kann eine so genannte "Built-in-Variante" verwendet werden. Die TX-Detektionselemente (zweite Antennenspulen 15) sind in der Regel geometrisch gleich gebaut, so dass sie die gleiche Amplitudenempfindlichkeit besitzen. Für die Phase ist die Kabellänge vom TX-Detektionselement bis zur Auswerteeinrichtung relevant. Ohne die Nutzung aktiver Elektronik sind die Kabellängenunterschiede gegenüber der Wellenlänge gering und können vernachlässigt werden.

Eine genaue Kalibrierung kann notwendig sein, falls die Genauigkeit der obigen Kalibrierung nicht ausreicht oder die Signale durch die aktive Elektronik transmittiert werden. So kann etwa zur besseren Nutzung der Daten eventuell eine Phasen-Kalibrierung der TX-Detektionselemente und der dahinterliegenden RX-Kette nötig sein. Diese kann durch vorherige Phasenkalibrierung der einzelnen Bauteile und Speicherung der Phasen geschehen. Alternativ kann eine genaue Kalibrierung durch eine so genannte Tune-up-Messung unter definierten Bedingungen für jede Lokalspule mit darauf befindlichen TX-Detektionselementen erfolgen.

Eine genaue geometrische Zuordnung der TX-Detektionselemente ist möglich, indem ihre Lage im Spulengehäuse der Lokalspulenvorrichtung in entsprechende Metadaten am System beschrieben wird. Nicht ortsfeste Spulen können durch verschiedene Verfahren (z. B. mittels Hall-Sensoren) in ihrer Position detektiert werden, um die aktuelle räumliche Position zu ermitteln.

Da die Nachverarbeitung der Daten im Digitalempfänger davon abhängt, wie die Daten nachher genutzt werden sollen, ist auch ein Umschalten des Digitalempfängers zwischen Sende- und Empfangsphase nötig. Diese kann mit den von der entsprechenden Anwendung (z. B. SAR-Überwachung, Bewegungsdetektion, etc.) gewünschten Parametern bezüglich der Auflösebandbreite der Daten parametrisiert werden.

Die nachfolgenden Anwendungen können auf einen Vergleich der einzelnen TX-Detektionssignale untereinander oder auf einen Vergleich mit den originalen TX-Pulsen zurückgreifen, um Rückschlüsse für die weitere Fragestellung beispielsweise bezüglich SAR, Bewegung, etc., ableiten zu können. Parasitäre Schwankungen des TX-Systems z. B. durch Erwärmung des Senders oder Veränderungen im Abstand zwischen Körperspule und Gradientenspule können durch mitlaufende Beobachtung und Subtraktion dieser langsamen Effekte kompensiert werden.

FIG 4 zeigt ein Ausführungsbeispiel eines erfindungsgemäßen Verfahrens, wobei die Schritte S1 bis S3 optional sind. In einem ersten Schritt S1 wird beispielsweise die Lokalspulenvorrichtung in einen RX-Erfassungsmodus geschaltet. In einem zweiten Schritt S2 werden mittels der ersten Sensoreinrichtung 11 der Lokalspulenvorrichtung Magnetresonanzsignale erfasst. Anschließend wird die Lokalspulenvorrichtung entsprechend Schritt S3 in einen TX-Erfassungsmodus geschaltet. Daran anschließend erfolgt gemäß Schritt S4 ein Erfassen des Sendefelds des Magnetresonanzsystems durch die zweite Sensoreinrichtung 12 der Lokalspulenvorrichtung 6.

In vorteilhafter Weise werden erfindungsgemäß somit klassische RX-Lokalspulen um eines oder mehrere TX-Erfassungselemente für die Messung der Anregungs- beziehungsweise Sendefelder nahe am Objekt beziehungsweise Patienten erweitert. Gegebenenfalls können bestehende Lokalspulen mit solchen TX-Erfassungselementen nachgerüstet werden. Die Akquisition der TX-Felddaten kann potentiell zur Verbesserung der SAR-Überwachung, für die Bewegungsdetektion oder zur Verbesserung der Patientensicherheit sowie zur Optimierung der Bildqualität (B1-Homogenität) eingesetzt werden.

## Patentansprüche

1. Lokalspulenvorrichtung (6) für ein Magnetresonanzsystem (1) mit
- einer ersten Sensoreinrichtung (11) zum Erfassen von Magnetresonanzsignalen,
**gekennzeichnet durch**
- eine zweite Sensoreinrichtung (12) zum Erfassen eines Anregungssignals des Magnetresonanzsystems (1), wobei
- das Anregungssignal zur Anregung der Magnetresonanzsignale durch das Magnetresonanzsystem (1) ausgelegt ist.

2. Lokalspulenvorrichtung (6) nach Anspruch 1, wobei die erste Sensoreinrichtung (11) und die zweite Sensoreinrichtung (12) (mindestens) eine Antennenspule gemeinsam besitzen, die erste Sensoreinrichtung (11) eine erste Elektronikeinheit (14) zum Verarbeiten der mittels der Antennenspule erfassten Magnetresonanzsignale und die zweite Sensoreinrichtung (12) eine von der ersten verschiedene zweite Elektronikeinheit (16) zur Signalverarbeitung des erfassten Anregungssignals besitzt, und die Lokalspulenvorrichtung (6) eine Schalteinrichtung (18) aufweist, mit der die Antennenspule wechselweise zur ersten oder zweiten Sensoreinrichtung schaltbar ist.

3. Lokalspulenvorrichtung (6) nach Anspruch 2, wobei die erste Elektronikeinheit (14) eine niedrigere Dämpfung oder eine höhere Verstärkung aufweist als die zweite Elektronikeinheit.

4. Lokalspulenvorrichtung (6) nach Anspruch 1, wobei die erste Sensoreinrichtung (11) eine erste Antennenspule (13) und die zweite Sensoreinrichtung (12) eine von der ersten verschiedene zweite Antennenspule (15) besitzt.

5. Lokalspulenvorrichtung (6) nach Anspruch 4, wobei die erste Sensoreinrichtung (11) und die zweite Sensoreinrichtung (12) eine gemeinsame Elektronikeinheit zur Signalverarbeitung und einen gemeinsamen Signalausgang (17) besitzen.

6. Lokalspulenvorrichtung (6) nach Anspruch 4 oder 5, wobei die erste Antennenspule (13) der ersten Sensoreinrichtung (11) zusammen mit der zweiten Antennenspule (15) der zweiten Sensoreinrichtung (12) auf einer gemeinsamen Leiterplatte angeordnet ist.

7. Lokalspulenvorrichtung (6) nach Anspruch 4, die einen Signalausgangspfad aufweist, wobei die erste Sensoreinrichtung (11) und die zweite Sensoreinrichtung (12) über einen Schalter an den Signalausgangspfad schaltbar sind.

8. Lokalspulenvorrichtung (6) nach einem der vorhergehenden Ansprüche, wobei sämtliche Antennenspulen der ersten Sensoreinrichtung (11) und sämtliche Antennenspulen der zweiten Sensoreinrichtung (12) über einen gemeinsamen Frequenzmultiplexer an einen gemeinsamen Signalausgangspfad der Lokalspulenvorrichtung (6) schaltbar sind.

9. Lokalspulenanordnung mit einer Lokalspulenvorrichtung (6) nach einem der vorhergehenden Ansprüche und mit einer daran signaltechnisch angeschlossenen Auswerteeinrichtung (19), die ausgebildet ist zum nicht ausschließlich binären, quantitativen Ermitteln einer Signalstärke des von der Lokalspulenvorrichtung (6) erfassten Anregungssignals des Magnetresonanzsystems (1) innerhalb eines vorgegebenen Signalstärkebereichs.

10. Lokalspulenanordnung nach Anspruch 8, wobei die zweite Sensorvorrichtung (12) eine oder mehrere Antennen aufweist, und
eine jeweilige Relativposition jeder Antenne innerhalb der Lokalspulenvorrichtung (6) für die Auswerteeinrichtung (19) zur Optimierung einer Homogenität des Anregungssignals zur Verfügung gestellt ist.

11. Lokalspulenanordnung nach Anspruch 8 oder 9, die in einen ersten Zustand des Erfassens mit der ersten Sensoreinrichtung (11) und in einen zweiten Zustand des Erfassens mit der zweiten Sensoreinrichtung (12) schaltbar ist, wobei die Auswerteeinrichtung (19) dazu eingerichtet ist, dass eine Auflösungsbandbreite der Auswerteeinrichtung automatisch in Abhängigkeit von dem jeweiligen Zustand parametrisiert wird.

12. Verfahren zum Betreiben einer Lokalspulenvorrichtung (6) für ein Magnetresonanzsystem (1), die mit einer ersten Sensoreinrichtung (11) zum Erfassen von Magnetresonanzsignalen ausgestattet ist,
**gekennzeichnet durch**
- Erfassen eines Anregungssignals des Magnetresonanzsystems (1) mittels einer zweiten Sensoreinrichtung (12) der Lokalspulenvorrichtung (6), wobei
- das Anregungssignal zur Anregung der Magnetresonanzsignale durch das Magnetresonanzsystem (1) ausgelegt ist.

13. Magnetresonanzsystem (1) mit einer Lokalspulenvorrichtung (6) nach einem der Ansprüche 1 bis 11, wobei der Magnetresonanztomograph (1) eine Sende-Empfangseinheit (10) aufweist, die über einen Signalausgangspfad der in Signalverbindung mit der Lokalspulenvorrichtung (6) ist, wobei die Sende-Empfangseinheit (10) ausgelegt ist, wahlweise ein von der Lokalspuleneinrichtung 6 erfasstes Magnetresonanzsignal und/oder Anregungssignal auszuwerten.
